# EUROPEAN PATENT APPLICATION

(11) **EP 3 244 420 A1**
(43) Date of publication of application: **15.11.2017**
(21) Application number: 16737178.0
(22) Date of filing: 06.01.2016
(51) Int. Cl.: H01B 1/22, C09D 5/10, C09D 5/24, C09D 7/12, C09D 129/14, C09D 139/06, C09D 201/00, H01B 1/00, H01B 5/14, H01B 13/00, H05K 1/09, H05K 3/12

(54) **ELECTROCONDUCTIVE PASTE AND METHOD FOR MANUFACTURING ELECTROCONDUCTIVE FILM USING SAME**

(30) Priority: 13.01.2015 JP 2015004425
(71) Applicant: Dowa Electronics Materials Co., Ltd., Chiyoda-ku Tokyo 101-0021 (JP)
(72) Inventor: FUJITA, Hidefumi, Okayama-shi Okayama 702-8053 (JP); KANEDA, Shuji, Okayama-shi Okayama 702-8032 (JP); MURANO, Yu, Tachikawa-shi Tokyo 190-0023 (JP); ITOH, Daisuke, Okayama-shi Okayama 700-0912 (JP)
(74) Representative: Manitz Finsterwald Patentanwälte PartmbB
(86) International application number: PCT/JP2016/000032
(87) International publication number: WO 2016/114105

(57) **Abstract**

After there is prepared a conductive paste which contains fine copper particles having an average particle diameter of 1 to 100 nm, each of the fine copper particles being coated with an azole compound, such as benzotriazole, coarse copper particles having an average particle diameter of 0.3 to 20 *µ*m, at least one of a polyvinylpyrrolidone (PVP) resin and a polyvinyl butyral (PVB) resin, a chlorine compound, and a glycol solvent, such as ethylene glycol, the total amount of the fine copper particles and the coarse copper particles being 50 to 90 % by weight, and the weight ratio of the fine copper particles to the coarse copper particles being in the range of from 1:9 to 5:5, the conductive paste thus prepared is applied on a substrate by screen printing to be preliminary-fired by vacuum drying, and then, fired with light irradiation by irradiating with light having a wavelength of 200 to 800 nm at a pulse period of 500 to 2000 *µ*s and a pulse voltage of 1600 to 3800 V to form a conductive film on the substrate.

## Description

### Technical Field

The present invention relates generally to a conductive paste. More specifically, the invention relates to a conductive paste for use in the production of a conductive film for forming electrodes and circuits of electronic parts and so forth, and a method for producing a conductive film using the same.

### Background Art

As a conventional method for producing a conductive film using a conductive paste, there is proposed a method for applying a photosensitive paste, which contains fine inorganic particles, such as fine glass particles, a photosensitive organic constituent, and a compound having an azole structure, such as benzotriazole, on a substrate to expose, develop and fire the applied paste to form a pattern (of a conductive film) (see, e.g., Patent Document 1). There is also proposed a method for printing a copper ink solution containing copper nanoparticles on the surface of a substrate, and then, causing the printed solution to be dried and exposed to pulses for fusing copper nanoparticles with light sintering, to produce a light-sintered copper nanoparticle film (a conductive film) (see, e.g., Patent Document 2). Moreover, there is proposed a conductive ink using, as a conductive filler, fine copper particles, each of which has benzotriazole deposited on the surface thereof as a process for improving resistance to oxidation (see, e.g., Patent Document 3).

### Prior Art Document(s)

### Patent Document(s)

Patent Document 1: Japanese Patent Laid-Open No. 9-218508 (Paragraph Numbers 0010-0056)
Patent Document 2: Japanese Patent Laid-Open No. 2010-528428 (Paragraph Numbers 0009-0014)
Patent Document 3: Japanese Patent Laid-Open No. 2008-285761 (Paragraph Numbers 0008-0010)

### Summary of the Invention

### Problem to be solved by the Invention

However, in the method of Patent Document 1, it is required to apply the photosensitive paste on the substrate to cause the applied paste to be exposed and developed with a developing agent, and then, to be fired at a high temperature (520 to 610 °C), so that the process is complicated. In addition, it is not possible to fire the paste with light irradiation, and it is not possible to form the pattern on a substrate which is easily affected by heat, such as a paper or a polyethylene terephthalate (PET) film. In the method of Patent Document 2, the storage stability of the copper ink solution containing copper nanoparticles is not sufficient, and the adhesion thereof to a substrate, such as a paper, is not sufficient. Moreover, if the conductive ink of Patent Document 3 is used as a conductive paste for light firing, when the ink is applied on the substrate to be dried and fired with light irradiation to form a conductive film, cracks are formed in the conductive film to deteriorate the electrical conductivity of the film.

It is therefore an object of the present invention to eliminate the aforementioned problems and to provide a conductive paste, which is able to form a conductive film having good adhesion to a substrate and a good electrical conductivity with light firing and which has a good storage stability, and a method for producing a conductive film using the same.

### Means for solving the Problem

In order to accomplish the aforementioned and other objects, the inventors have diligently studied and found that it is possible to produce a conductive paste, which is able to form a conductive film having good adhesion to a substrate and a good electrical conductivity with light firing and which has a good storage stability, if fine copper particles having an average particle diameter of 1 to 100 nm, each of which is coated with an azole compound, coarse copper particles having an average particle diameter of 0.3 to 20 *µ*m, a resin and a chlorine compound are added to a glycol solvent. Thus, the inventors have made the present invention.

According to the present invention, there is provided a conductive paste comprising: fine copper particles having an average particle diameter of 1 to 100 nm, each of the fine copper particles being coated with an azole compound; coarse copper particles having an average particle diameter of 0.3 to 20 *µ*m; a resin; a chlorine compound; and a glycol solvent.

In this conductive paste, the chlorine compound is preferably at least one selected from the group consisting of sodium chloride, calcium chloride, chloroform and trichloroacetic acid. The total amount of the fine copper particles and coarse copper particles in the conductive paste is preferably 50 to 90 % by weight. The weight ratio of the fine copper particles to the coarse copper particles in the conductive paste is preferably in the range of from 1:9 to 5:5. The azole compound is preferably benzotriazole, and the glycol solvent is preferably ethylene glycol. The resin is preferably at least one of a polyvinylpyrrolidone resin and a polyvinyl butyral resin. The conductive paste preferably contains a dispersing agent.

According to the present invention, there is provided a method for producing a conductive film, the method comprising the steps of: applying the above-described conductive paste on a substrate; and causing the applied paste to be preliminary-fired, and then, to be fired with light irradiation to form a conductive film on the substrate.

In this method for producing a conductive film, the applying of the conductive paste is preferably carried out by screen printing. The preliminary-firing is preferably carried out by vacuum drying at 50 to 200 °C. The light irradiation is preferably carried out by pulse-irradiation with light having a wavelength of 200 to 800 nm at a pulse period of 500 to 2000 *µ*s and a pulse voltage of 1600 to 3800 V. The conductive film preferably has a thickness of 1 to 30 *µ*m.

### Effects of the Invention

According to the present invention, it is possible to provide a conductive paste, which is able to form a conductive film having good adhesion to a substrate and a good electrical conductivity with light firing and which has a good storage stability, and a method for producing a conductive film using the same.

### Brief Description of the Drawings

FIG. 1 is a plan view showing the shape of a conductive paste applied on a substrate in examples and comparative examples.
FIG. 2 is a chart showing the absorbance of a dispersing solution containing fine copper particles in Example 1.

### Mode for Carrying Out the Invention

The preferred embodiment of a conductive paste according to the present invention, comprises: fine copper particles having an average particle diameter of 1 to 100 nm, each of the fine copper particles being coated with an azole compound; coarse copper particles having an average particle diameter of 0.3 to 20 *µ*m; a resin; a chlorine compound; and a glycol solvent.

The fine copper particles having an average particle diameter of 1 to 100 nm are easily sintered. If the surface of each of such fine copper particles is coated with an azole compound, it is possible to improve the storage stability of the fine copper particles, and it is possible to improve the light absorbability thereof, so that the fine copper particles are easily sintered with light irradiation. In particular, since the azole compound has a conjugated double band in the molecule thereof, it is designed to absorb light having a wavelength range (200-400 nm) of ultraviolet rays to convert the absorbed light to heat for causing the fine copper particles to be easily sintered.

The coarse copper particles having an average particles diameter of 0.3 to 20 *µ*m are designed to restrain the contraction of a conductive film due to the sintering of the fine copper particles to prevent cracks from being formed in the conductive film to prevent the electrical conductivity thereof from being deteriorated when the copper particles are fired with light irradiation to form the conductive film. The coarse copper particles are also designed to restrain the deterioration of the electrical conductivity of the conductive film even if the thickness thereof is increased.

In this conductive paste, the total amount of the fine copper particles and coarse copper particles is preferably 50 to 90 % by weight, and more preferably 60 to 80 % by weight. The ratio of the weight of the fine copper particles to the weight of the coarse copper particles is preferably in the range of from 1:9 to 5:5 (from 1/9 to 5/5) and more preferably in the range of from 2:8 to 4:6 (from 2/8 to 4/6). The azole compound is preferably benzotriazole.

When the conductive paste is applied on a substrate, such as a paper, to form a conductive film, the solvent of the conductive paste is preferably water-soluble in order to improve the wettability of the substrate, and preferably has a hydroxyl group having the function of reducing copper which is easily oxidizable. The solvent preferably has a boiling point of not lower than 180 °C so that the conductive paste can be continuously printed on the substrate. As a solvent having such characteristics, the glycol solvent comprising glycol or a derivative thereof is used in the preferred embodiment of a conductive paste according to the present invention. As the glycol solvent, there can be used ethylene glycol, isopropylene glycol, 1,6-hexanediol, 1,3-propanediol, 1,4-butanediol, dipropylene glycol, 1,5-pentanediol, diethylene glycol, polyethylene glycol (having a molecular weight of about 200), methylpentanediol, triethylene glycol or the like, and there is preferably used ethylene glycol.

The chlorine compound may be an inorganic chlorine compound or an organic chlorine compound. As the inorganic chlorine compound, there may be used sodium chloride, calcium chloride, potassium chloride or the like. As the organic chlorine compound, there may be used chloroform, trichloroacetic acid, 2-methoxyethoxymethyl chloride, trimethylstearyl ammonium chloride or the like. These chloride compounds are preferably added so that the weight ratio (Cl/Cu) of Cl to Cu is in the range of from 0.1 % by weight to 1.5 % by weight, and are preferably added so that the weight ratio of Cl to the conductive paste is in the range of from 0.1 % by weight to 1.0 % by weight.

When the conductive paste is applied on a substrate, such as a paper, to form a conductive film, the resin contained in the conductive paste is preferably a resin which can improve the adhesion of the conductive paste to the substrate, which can be intensely dissolved in a glycol solvent to cause the conductive paste to have suitable viscosity and sagging, and which can form a flexible conductive film. As a resin having such characteristics, there is preferably used at least one of a polyvinylpyrrolidone (PVP) resin and a polyvinyl butyral (PVB) resin.

When the conductive paste contains the polyvinylpyrrolidone resin, the amount of the polyvinylpyrrolidone resin in the conductive paste is preferably 3 to 9 % by weight with respect to the total amount of the fine copper particles and coarse copper particles. When the conductive paste contains the polyvinyl butyral resin, the amount of the polyvinyl butyral resin in the conductive paste is preferably 3 to 6 % by weight with respect to the total amount of the fine copper particles and coarse copper particles.

As the polyvinylpyrrolidone resin, there can be used, e.g., PITZCOL K-30 (Weight-Average Molecular Weight 45,000) and PITZCOL K-90 (Weight-Average Molecular Weight 1,200,000) commercially available from DKS Co., Ltd., PVP K-25 (Weight-Average Molecular Weight 20,000) commercially available from Wako Pure Chemical Industries, Ltd., and so forth. As the polyvinyl butyral resin, there can be used, e.g., S-LEC B-Series and S-LEC K-Series commercially available from Sekisui Chemical Co., Ltd., Mowital B-Series commercially available from Kuraray Co., Ltd., and so forth.

In the conductive paste, a dispersing agent is preferably added to the solvent in order to improve the dispersibility of the fine copper particles. The amount of the dispersing agent to be added is preferably in the range of from 0.1 % by weight to 10 % by weight with respect to the conductive paste, and more preferably in the range of from 0.1 % by weight to 2 % by weight with respect to the conductive paste. As such a dispersing agent, there may be used a dispersing agent which is compatible with the surface of the fine copper particles and which is compatible with the glycol solvent.

As examples of dispersing agents having such characteristics, there are dispersing agents of surfactants, such as non-ionic polyoxyethylene (e.g., TRITON X-100 commercially available from Sigma-Aldrich Co., Ltd.), polyoxyethylene (8) octylphenylether (e.g., TRITON X-114 commercially available from Sigma-Aldrich Co., Ltd.), high-molecular-weight block copolymer (e.g., DISPERBYK-190 commercially available from BYK-Chmemie Japan, Co., Ltd.), denaturated acrylic block copolymer (e.g., DISPERBYK-2000 and DISPERBYK-2001 commercially available from BYK-Chmemie Japan, Co., Ltd.), non-ionic fluorinated polyoxyethylene (e.g., Zonyl FS300 commercially available from Du Pont Kabushiki Kaisha), fluorine group/hydrophilic group containing oligomer (e.g., MEGAFAC EXP TF-1540, MEGAFAC EXP TF-1878 and MEGAFAC F-480SF commercially available from DIC Corporation), lauryl trimethyl ammonium chloride (e.g., Cortamine 24P commercially available from Kao Corporation), polyoxyethylene palmalkyl amine (e.g., AMIET 102 commercially available from Kao Corporation), polyoxyethylene distyrenized phenylether (e.g., EMULGEN A-60 commercially available from Kao Corporation), specialized polycarboxylic acid type surfactant (e.g., DEMOL EP Kao Corporation), ammonium salt of naphthalene sulfonate formaldehyde condensate (e.g., MX-2045L commercially available from Kao Corporation), polyoxyethylene-lauryl amine (e.g., NYMEEN L-202 and MARIARIM HKM-150A commercially available from NOF Corporation), ammonium salt of half ester copolymer of styrene-maleic acid (e.g., DKS DISCOAT N-14 commercially available from DKS Co., Ltd.), polyoxyethylene styrenized phenylether (e.g., NOIGEN EA-167 commercially available from DKS Co., Ltd.), polyoxyethylene (20) nonylphenylether (e.g., commercially available from Wako Pure Chemical Industries, Ltd.), cationic surfactant (e.g., NOPCO SPARSE 092 commercially available from SAN NOPCO LIMITED), and ethylene oxide additive of acetylenediol (e.g., Dynol 604 commercially available from Nissin Chemical Co., Ltd.).

The conductive paste may contain an addition agent, such as a rheology control agent, an adhesion giving agent and a defoaming agent.

Furthermore, in the preferred embodiment of a method for producing a conductive film, kneading and defoaming are preferably carried out by means of a defoaming mixer, a three-roll mill, a planet ball mill, a bead mill, a mortar or the like.

In the preferred embodiment of a method for producing a conductive film, the above-described conductive paste is applied on a substrate to be preliminary-fired, and then, fired with light irradiation to form a conductive film on the substrate.

In this method for producing a conductive film, the applying of the conductive paste is preferably carried out by screen printing. The preliminary-firing of the applied paste is preferably carried out by heating the applied paste by means of a vacuum dryer, an IR lamp heater or the like. When the preliminary-firing is carried out by means of a vacuum dryer, the vacuum drying is preferably carried out at 50 to 200 °C for 10 to 180 minutes. When the preliminary-firing is carried out by means of an IR lamp heater, the applied paste is preferably heated at a quantity of heat of 140 to 600 J for 5 to 20 seconds in the atmosphere. The light irradiation is preferably carried out by irradiating with light having a wavelength of 200 to 800 nm at a pulse period of 500 to 2000 *µ*s and a pulse voltage of 1600 to 3800 V. The light irradiation can be carried out by irradiating with light by means of a xenon flash lamp or the like, and can be carried out in a short period of time (in about one to two pulses) in the atmosphere. The light irradiation may be repeated several times. By this light irradiation, it is possible to form a conductive film which has a thickness of 1 to 30 *µ*m and which has a good electrical conductivity.

Throughout the specification, the expression "average particle diameter" means an average primary particle diameter calculated from a field emission type scanning electron microscope (FE-SEM). The "average primary particle diameter" can be calculated as follows. For example, the fine copper particles or the coarse copper particles are observed by means of a field emission type scanning electron microscope (FE-SEM) (S-4700 produced by Hitachi Ltd.) at a predetermined magnification (a magnification of 100,000 when the fine copper particles are observed, and a magnification of 2,000 to 20,000 in accordance with the shape and/or size of the coarse copper particles when the coarse copper particles are observed). Then, optional 100 fine copper particles or 100 coarse copper particles on the FE-SEM image (a plurality of FE-SEM images if necessary) are selected at random. Then, the particle diameter (the long diameter on the image) of each of the selected particles (primary particles) is measured. By the number average of the measured particle diameters, the average particle diameter of the fine or coarse copper particles can be calculated (as the number average particle diameter).

### Examples

Examples of a conductive paste and a method for producing a conductive film using the same according to the present invention will be described below in detail.

### [Example 1]

First, there were prepared a solution A obtained by allowing 280 g of copper sulfate pentahydrate (commercially available from JX Nippon Mining & Metals Corporation) serving as a copper source and 1 g of benzotriazole (BTA) (commercially available from Wako Pure Chemical Industries, Ltd.) to be dissolved in 1330 g of pure water, a solution B obtained by allowing 200 g of an aqueous solution containing 50 % by weight of sodium hydroxide (commercially available from Wako Pure Chemical Industries, Ltd.) serving as a neutralizer to be diluted with 900 g of pure water, and a solution C obtained by allowing 150 g of hydrazine monohydrate containing 80 % by weight of hydrazine (commercially available from Otsuka Chemical Co., Ltd.) as a reducing agent to be diluted with 1300 g of pure water.

Then, the solution A and the solution B were mixed with each other while being stirred, and the temperature of the mixed solution was adjusted to 60 °C. Thereafter, while maintaining the stirring, all of the solution C was added to the mixed solution within 30 seconds. After about 5 minutes, the reaction was completed to produce a slurry. The solid-liquid separation of the slurry was carried out to obtain a solid material. Then, ethylene glycol (EG) (commercially available from Wako Pure Chemical Industries, Ltd.) was allowed to pass through the solid material to obtain a dispersing solution in which fine copper particles coated with BTA were dispersed in ethylene glycol. The fine copper particles in this dispersing solution were observed by means of a field emission type scanning electron microscope (FE-SEM) (S-4700 produced by Hitachi Ltd.). As a result, the fine copper particles were substantially spherical fine particles (coated with BTA). The average particle diameter of the fine copper particles was calculated. As a result, the average particle diameter thereof was about 50 nm. The content of copper in the dispersing solution was obtained by the differential analysis of the dispersing solution in N₂. As a result, the content of copper therein was 70 % by weight.

Then, 49.00 g of flake-shaped coarse copper particles having an average particle diameter of 12 *µ*m were added to 30.00 g of the dispersing solution of the fine copper particles coated with BTA (so that the ratio of the weight of the fine copper particles coated with BTA to the weight of the flake-shaped coarse copper particles was 3:7). To the dispersing solution, there were also added 2.10 g of a surfactant of ammonium salt of naphthalene sulfonate formaldehyde condensate (MX-2045L commercially available from Kao Corporation) serving as a dispersing agent, 7.00 g of an ethylene glycol solution containing 60 % by weight of a polyvinylpyrrolidone (PVP) resin having a weight-average molecular weight of 45,000 (PITZCOL K-30 commercially available from DKS Co., Ltd.), 8.00 g (weight ratio (Cl/Cu) of Cl to Cu = 0.35 % by weight) of a chlorine compound solution containing 5 % by weight of sodium chloride (NaCl) prepared by dissolving sodium chloride (commercially available from Wako Pure Chemical Industries, Ltd.) serving as a chlorine compound in ethylene glycol, and 3.90 g of ethylene glycol serving as an additional solvent. Thereafter, a rotary and revolutionary vacuum defoaming mixer (V-mini 30 produced by EME Co., Ltd.) was used for causing the mixture thus obtained to be rotated at a rotation speed of 1400 rpm for 60 seconds to knead and defoam the mixture so as to uniformly disperse conductive fillers. Then, the kneaded and defoamed mixture was caused to pass through a three-roll mill to be uniformly dispersed to obtain 100 g of a conductive paste containing the fine copper particles coated with BTA (conductive filler 1) and the flake-shaped coarse copper particles (conductive filler 2) as conductive fillers. Furthermore, the content of the conductive fillers in the conductive paste thus obtained was 70 % by weight, and the weight ratio of Cl to the conductive paste was 0.24 % by weight. The maximum particle diameter in the obtained conductive paste was 15 *µ*m or less when it was evaluated by a grind gage.

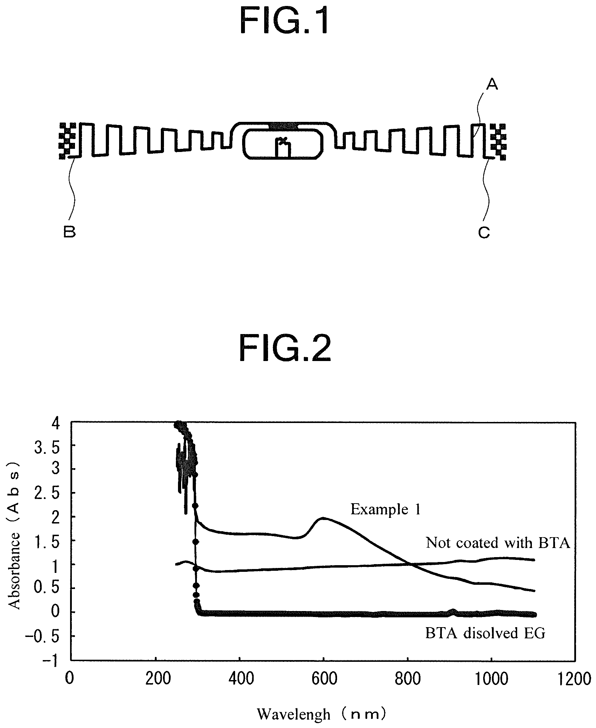

Then, a screen printing plate having the number of meshes of 250 LPI, a wire diameter of 30 *µ*m, a gauze thickness of 60 *µ*m and an emulsion thickness of 5 *µ*m (ST250-30-60 commercially available from SONOCOM Co., Ltd.) was used for causing the above-described conductive paste to be printed in the shape of an antenna (the shape shown in FIG. 1) having a conductive length of 240 mm on a substrate (Coating Paper DF Color M70 commercially available from Mitsubishi Paper Mills Limited) by screen printing. After a vacuum dryer was used for causing the printed conductive paste to be vacuum dried at 100 °C for 60 minutes as preliminary-firing to obtain a preliminary-fired film, a pulse irradiating apparatus (Sinteron 2000 produced by Xenon Corporation) was used for irradiating the preliminary-fired film with one pulse (2000 *µ*s) of light having a wavelength of 200 to 800 nm at a pulse period of 2000 *µ*s and a pulse voltage of 2700 V by means of a xenon flash lump to fire the preliminary-fired film to obtain a conductive film.

The thickness of the conductive film was obtained by calculating an average value of height differences between the surface of the conductive film and the surface of the substrate having the conductive film, the height differences being measured at 100 spots by means of a laser microscope (VK-9700 produced by KEYENCE CORPORATION). As a result, the thickness of the conductive film was 13.0 *µ*m. The line width (of a portion shown by A in FIG. 1) of the conductive film was 572 *µ*m. The electrical resistance (line resistance) of the conductive film (between B and C in FIG. 1) was measured by means of a tester (CDM-03D produced by CUSTOM CORPORATION). As a result, the electrical resistance was 11.3 Ω. The volume resistivity of the conductive film was obtained from the thickness, electrical resistance and area of the conductive film. As a result, the volume resistivity was 35.0 *µ*Ω · cm.

In order to evaluate the adhesion of the conductive paste to the substrate, a cellophane tape having a width of 24 mm (Nichiban Co., Ltd.) was applied on the conductive film formed on the substrate, and a load of about 5 kg was applied thereon. Then, the cellophane tape was rubbed at the load so as to remove bubbles between the wiring and the cellophane tape. Thus, the bubbles were removed to allow the cellophane tape to be adhered to the substrate. Thereafter, the substrate was fixed, and the cellophane tape was lifted to be stripped from the substrate in a period of time of about 0.6 seconds without stopping so that the angle between the substrate and the tape was carefully maintained to be about 90 degrees. When no separated part of the conductive film was adhered to the tape, it was evaluated that the adhesion of the conductive film was very good. When the separated part of the conductive film was hardly adhered to the tape, it was evaluated that the adhesion of the conductive film was good. When only a part of the edge of the conductive film was peeled off, it was evaluated that the adhesion of the conductive film was not good. When the conductive film was broken and peeled off so that it was not possible to measure the line resistance thereof, it was evaluated that the adhesion of the conductive film was bad. As a result, the adhesion of the wiring was good in this example.

After the conductive paste obtained in this example was allowed to stand at room temperature in an atmosphere of nitrogen for one month, the presence of aggregation was checked with eyes. As a result, no aggregation was observed. The conductive paste after being thus allowed to stand for one month was used for producing a conductive film by the same method as the above-described method. As a result, the electrical resistance and volume resistivity of the conductive film were hardly varied.

### [Example 2]

A conductive paste was obtained by the same method as that in Example 1, except that 8.00 g (weight ratio (Cl/Cu) of Cl to Cu = 0.37 % by weight) of a chlorine compound solution containing 5 % by weight of calcium chloride (CaCl₂) prepared by dissolving calcium chloride (commercially available from Wako Pure Chemical Industries, Ltd.) in ethylene glycol was used as the chlorine compound. Furthermore, the content of the conductive fillers in the conductive paste was 70 % by weight, and the weight ratio of Cl to the conductive paste was 0.26 % by weight.

This conductive paste was used for producing a conductive film by the same method as that in Example 1. By the same methods as those in Example 1, the thickness and line width of the conductive film were obtained, and the electrical resistance (line resistance) thereof was measured. In addition, the volume resistivity thereof was obtained, and the adhesion thereof to the substrate was evaluated. As a result, the thickness of the conductive film was 13.2 *µ*m, the line width thereof was 578 *µ*m, and the electrical resistance (line resistance) thereof was 13.5 Ω. The volume resistivity thereof was 43.0 *µ*Ω · cm, and the adhesion thereof to the substrate was good.

After the conductive paste obtained in this example was allowed to stand at room temperature in an atmosphere of nitrogen for one month, the presence of aggregation was checked with eyes. As a result, no aggregation was observed. The conductive paste after being thus allowed to stand for one month was used for producing a conductive film by the same method as the above-described method. As a result, the electrical resistance and volume resistivity of each of the conductive films were hardly varied.

### [Example 3]

A conductive paste was obtained by the same method as that in Example 1, except that 8.00 g (weight ratio (Cl/Cu) of Cl to Cu = 0.51 % by weight) of a chlorine compound solution containing 5 % by weight of chloroform (CHCl₃) prepared by dissolving chloroform (commercially available from Wako Pure Chemical Industries, Ltd.) in ethylene glycol was used as the chlorine compound. Furthermore, the content of the conductive fillers in the conductive paste was 70 % by weight, and the weight ratio of Cl to the conductive paste was 0.36 % by weight.

This conductive paste was used for producing a conductive film by the same method as that in Example 1, except that the pulse voltage was 2500 V. By the same methods as those in Example 1, the thickness and line width of the conductive film were obtained, and the electrical resistance (line resistance) thereof was measured. In addition, the volume resistivity thereof was obtained, and the adhesion thereof to the substrate was evaluated. As a result, the thickness of the conductive film was 11. 8 *µ*m, the line width thereof was 620 *µ*m, and the electrical resistance (line resistance) thereof was 16.1 Ω. The volume resistivity thereof was 49.0 *µ*Ω · cm, and the adhesion thereof to the substrate was good.

After the conductive paste obtained in this example was allowed to stand at room temperature in an atmosphere of nitrogen for one month, the presence of aggregation was checked with eyes. As a result, no aggregation was observed. The conductive paste after being thus allowed to stand for one month was used for producing a conductive film by the same method as the above-described method. As a result, the electrical resistance and volume resistivity of each of the conductive films were hardly varied.

### [Example 4]

A conductive paste was obtained by the same method as that in Example 1, except that 8.00 g (weight ratio (Cl/Cu) of Cl to Cu = 0.37 % by weight) of a chlorine compound solution containing 5 % by weight of trichloroacetic acid (CCl₃COOH) prepared by dissolving trichloroacetic acid (commercially available from Wako Pure Chemical Industries, Ltd.) in ethylene glycol was used as the chlorine compound. Furthermore, the content of the conductive fillers in the conductive paste was 70 % by weight, and the weight ratio of Cl to the conductive paste was 0.26 % by weight.

This conductive paste was used for producing a conductive film by the same method as that in Example 1, except that the pulse voltage was 2600 V. By the same methods as those in Example 1, the thickness and line width of the conductive film were obtained, and the electrical resistance (line resistance) thereof was measured. In addition, the volume resistivity thereof was obtained, and the adhesion thereof to the substrate was evaluated. As a result, the thickness of the conductive film was 11.5 *µ*m, the line width thereof was 613 *µ*m, and the electrical resistance (line resistance) thereof was 13.6 Ω. The volume resistivity thereof was 40.0 *µ*Ω · cm, and the adhesion thereof to the substrate was good.

After the conductive paste obtained in this example was allowed to stand at room temperature in an atmosphere of nitrogen for one month, the presence of aggregation was checked with eyes. As a result, no aggregation was observed. The conductive paste after being thus allowed to stand for one month was used for producing a conductive film by the same method as the above-described method. As a result, the electrical resistance and volume resistivity of each of the conductive films were hardly varied.

### [Example 5]

A conductive paste was obtained by the same method as that in Example 1, except that 4.00 g (weight ratio (Cl/Cu) of Cl to Cu = 0.17 % by weight) of a chlorine compound solution containing 5 % by weight of sodium chloride (NaCl) prepared by dissolving sodium chloride (commercially available from Wako Pure Chemical Industries, Ltd.) in ethylene glycol was used as the chlorine compound and that 7.90 g of ethylene glycol was added as the additional solvent. Furthermore, the content of the conductive fillers in the conductive paste was 70 % by weight, and the weight ratio of Cl to the conductive paste was 0.12 % by weight.

This conductive paste was used for producing a conductive film by the same method as that in Example 1, except that the pulse voltage was 2600 V. By the same methods as those in Example 1, the thickness and line width of the conductive film were obtained, and the electrical resistance (line resistance) thereof was measured. In addition, the volume resistivity thereof was obtained, and the adhesion thereof to the substrate was evaluated. As a result, the thickness of the conductive film was 15.0 *µ*m, the line width thereof was 612 *µ*m, and the electrical resistance (line resistance) thereof was 11.2 Ω. The volume resistivity thereof was 43.0 *µ*Ω · cm, and the adhesion thereof to the substrate was good.

After the conductive paste obtained in this example was allowed to stand at room temperature in an atmosphere of nitrogen for one month, the presence of aggregation was checked with eyes. As a result, no aggregation was observed. The conductive paste after being thus allowed to stand for one month was used for producing a conductive film by the same method as the above-described method. As a result, the electrical resistance and volume resistivity of each of the conductive films were hardly varied.

### [Example 6]

A conductive paste was obtained by the same method as that in Example 1, except that 26.25 g of a dispersing solution containing 80 % by weight of the fine copper particles coated with BTA was used, that 15.00 g (weight ratio (Cl/Cu) of Cl to Cu = 0.78 % by weight) of a chlorine compound solution containing 6 % by weight of sodium chloride (NaCl) prepared by dissolving sodium chloride (commercially available from Wako Pure Chemical Industries, Ltd.) in ethylene glycol was used as the chlorine compound and that 0.65 g of ethylene glycol was added as the additional solvent. Furthermore, the content of the conductive fillers in the conductive paste was 70 % by weight, and the weight ratio of Cl to the conductive paste was 0.55 % by weight.

This conductive paste was used for producing a conductive film by the same method as that in Example 1, except that the pulse voltage was 2500 V. By the same methods as those in Example 1, the thickness and line width of the conductive film were obtained, and the electrical resistance (line resistance) thereof was measured. In addition, the volume resistivity thereof was obtained, and the adhesion thereof to the substrate was evaluated. As a result, the thickness of the conductive film was 13.2 *µ*m, the line width thereof was 605 *µ*m, and the electrical resistance (line resistance) thereof was 8.1 Ω. The volume resistivity thereof was 27.0 *µ*Ω · cm, and the adhesion thereof to the substrate was good.

After the conductive paste obtained in this example was allowed to stand at room temperature in an atmosphere of nitrogen for one month, the presence of aggregation was checked with eyes. As a result, no aggregation was observed. The conductive paste after being thus allowed to stand for one month was used for producing a conductive film by the same method as the above-described method. As a result, the electrical resistance and volume resistivity of each of the conductive films were hardly varied.

### [Example 7]

A conductive paste was obtained by the same method as that in Example 1, except that 8.00 g (weight ratio (Cl/Cu) of Cl to Cu = 1.02 % by weight) of a chlorine compound solution containing 10 % by weight of chloroform (CHCl₃) prepared by dissolving chloroform (commercially available from Wako Pure Chemical Industries, Ltd.) in ethylene glycol was used as the chlorine compound. Furthermore, the content of the conductive fillers in the conductive paste was 70 % by weight, and the weight ratio of Cl to the conductive paste was 0.71 % by weight.

This conductive paste was used for producing a conductive film by the same method as that in Example 1, except that the pulse voltage was 2600 V. By the same methods as those in Example 1, the thickness and line width of the conductive film were obtained, and the electrical resistance (line resistance) thereof was measured. In addition, the volume resistivity thereof was obtained, and the adhesion thereof to the substrate was evaluated. As a result, the thickness of the conductive film was 12.7 *µ*m, the line width thereof was 590 *µ*m, and the electrical resistance (line resistance) thereof was 8.0 Ω. The volume resistivity thereof was 25.0 *µ*Ω · cm, and the adhesion thereof to the substrate was good.

After the conductive paste obtained in this example was allowed to stand at room temperature in an atmosphere of nitrogen for one month, the presence of aggregation was checked with eyes. As a result, no aggregation was observed. The conductive paste after being thus allowed to stand for one month was used for producing a conductive film by the same method as the above-described method. As a result, the electrical resistance and volume resistivity of each of the conductive films were hardly varied.

### [Example 8]

A conductive film was produced by the same method as that in Example 1, except that the conductive paste obtained in Example 6 was used, that a cast coated paper (Mira Coat commercially available from Marusho Chemical Co., Ltd.) was used as the substrate, and that the pulse voltage was 2600 V. By the same methods as those in Example 1, the thickness and line width of the conductive film were obtained, and the electrical resistance (line resistance) thereof was measured. In addition, the volume resistivity thereof was obtained, and the adhesion thereof to the substrate was evaluated. As a result, the thickness of the conductive film was 15.5 *µ*m, the line width thereof was 600 *µ*m, and the electrical resistance (line resistance) thereof was 8.8 Ω. The volume resistivity thereof was 34.0 *µ*Ω · cm, and the adhesion thereof to the substrate was good.

After the conductive paste obtained in this example was allowed to stand at room temperature in an atmosphere of nitrogen for one month, the presence of aggregation was checked with eyes. As a result, no aggregation was observed. The conductive paste after being thus allowed to stand for one month was used for producing a conductive film by the same method as the above-described method. As a result, the electrical resistance and volume resistivity of each of the conductive films were hardly varied.

### [Example 9]

A conductive film was produced by the same method as that in Example 1, except that the conductive paste obtained in Example 6 was used, that a coating paper (Raicho Coat commercially available from Chuetsu Pulp & Paper Co., Ltd.) was used as the substrate, and that the pulse voltage was 2600 V. By the same methods as those in Example 1, the thickness and line width of the conductive film were obtained, and the electrical resistance (line resistance) thereof was measured. In addition, the volume resistivity thereof was obtained, and the adhesion thereof to the substrate was evaluated. As a result, the thickness of the conductive film was 15.7 *µ*m, the line width thereof was 608 *µ*m, and the electrical resistance (line resistance) thereof was 10.8 Ω. The volume resistivity thereof was 43.0 *µ*Ω · cm, and the adhesion thereof to the substrate was good.

After the conductive paste obtained in this example was allowed to stand at room temperature in an atmosphere of nitrogen for one month, the presence of aggregation was checked with eyes. As a result, no aggregation was observed. The conductive paste after being thus allowed to stand for one month was used for producing a conductive film by the same method as the above-described method. As a result, the electrical resistance and volume resistivity of each of the conductive films were hardly varied.

### [Comparative Example 1]

A conductive paste was obtained by the same method as that in Example 1, except that the chlorine compound solution was not added and that the amount of ethylene glycol to be added was 11.9 g. Furthermore, the content of the conductive fillers in the conductive paste was 70 % by weight, and the weight ratio of Cl to the conductive paste was 0 % by weight.

This conductive paste was used for producing a conductive film by the same method as that in Example 1, except that the pulse voltage was 2800 V. By the same methods as those in Example 1, the thickness and line width of the conductive film were obtained, and the electrical resistance (line resistance) thereof was measured. In addition, the volume resistivity thereof was obtained, and the adhesion thereof to the substrate was evaluated. As a result, the thickness of the conductive film was 14.6 *µ*m, the line width thereof was 611 *µ*m, and the electrical resistance (line resistance) thereof was 16.7 Ω. The volume resistivity thereof was 62.0 *µ*Ω · cm, and the adhesion thereof to the substrate was good.

After the conductive paste obtained in this example was allowed to stand at room temperature in an atmosphere of nitrogen for one month, the presence of aggregation was checked with eyes. As a result, no aggregation was observed. The conductive paste after being thus allowed to stand for one month was used for producing a conductive film by the same method as the above-described method. As a result, the electrical resistance and volume resistivity of each of the conductive films were hardly varied.

### [Comparative Example 2]

A conductive paste was obtained by the same method as that in Example 1, except that the resin was not added and that 10.90 g of ethylene glycol was added as the additional solvent.

This conductive paste was used for producing a conductive film by the same method as that in Example 1, except that the pulse voltage was 2400 V. By the same methods as those in Example 1, the thickness and line width of the conductive film were obtained, and the electrical resistance (line resistance) thereof was measured. In addition, the volume resistivity thereof was obtained, and the adhesion thereof to the substrate was evaluated. As a result, the thickness of the conductive film was 7.0 *µ*m, the line width thereof was 720 *µ*m, and the electrical resistance (line resistance) thereof was 23.0 Ω. The volume resistivity thereof was 48.3 *µ*Ω · cm, and the adhesion thereof to the substrate was good.

After the conductive paste obtained in this example was allowed to stand at room temperature in an atmosphere of nitrogen for one month, the presence of aggregation was checked with eyes. As a result, no aggregation was observed. The conductive paste after being thus allowed to stand for one month was used for producing a conductive film by the same method as the above-described method. As a result, the electrical resistance and volume resistivity of each of the conductive films were hardly varied.

### [Comparative Example 3]

A conductive paste was obtained by the same method as that in Example 1, except that the amount of the dispersing solution of the fine copper particles coated with BTA was 80.00 g, that the flake-shaped coarse copper particles were not added, that the amount of the dispersing agent to be added was 5.60 g, that the amount of the resin to be added was 5.60 g, and that the amount of ethylene glycol to be added as the additional solvent was 0.8 g. Furthermore, the content of the conductive fillers in the conductive paste was 56 % by weight.

This conductive paste was used for attempting the production of a conductive film. However, it was not possible to fire the conductive paste, so that it was not possible to produce a conductive film.

Tables 1 through 3 show the producing conditions of the conductive pastes in these examples and comparative examples, and the thickness, line resistance, volume resistivity and adhesion of each of the conductive films produced by using the conductive pastes.

**Table 1**

| | Dispersing Solution of Fine Copper Particles coated with BTA | | Coarse Copper Particles (g) | Dispersing Agent (g) | Resin Solution (g) | Chlorine Compound Solution | | Additional Solvent (g) |
|---|---|---|---|---|---|---|---|---|
| | Concentration (wt%) | Weight (g) | | | | Kind | Weight (g) | |
| Ex.1 | 70 | 30.00 | 49.00 | 2.10 | 7.00 | 5% NaCl | 8.00 | 3.90 |
| Ex.2 | 70 | 30.00 | 49.00 | 2.10 | 7.00 | 5% CaCl₂ | 8.00 | 3.90 |
| Ex.3 | 70 | 30.00 | 49.00 | 2.10 | 7.00 | 5% CHCl₃ | 8.00 | 3.90 |
| Ex.4 | 70 | 30.00 | 49.00 | 2.10 | 7.00 | 5% CCl₃C OOH | 8.00 | 3.90 |
| Ex.5 | 70 | 30.00 | 49.00 | 2.10 | 7.00 | 5% NaCl | 4.00 | 7.90 |
| Ex.6 | 80 | 26.25 | 49.00 | 2.10 | 7.00 | 6% NaCl | 15.00 | 0.65 |
| Ex.7 | 70 | 30.00 | 49.00 | 2.10 | 7.00 | 10% CHCl₃ | 8.00 | 3.90 |
| Comp .1 | 70 | 30.00 | 49.00 | 2.10 | 7.00 | - | - | 11.9 0 |
| Comp .2 | 70 | 30.00 | 49.00 | 2.10 | 0.00 | 5% NaCl | 8.00 | 10.9 0 |
| Comp .3 | 70 | 80.00 | 0.00 | 5.60 | 5.60 | 5% NaCl | 8.00 | 0.80 |

**Table 2**

| | Cl (wt% to Cu) | Cl (wt% to Paste) | All Copper Particles (wt%) |
|---|---|---|---|
| Ex.1 | 0.35 | 0.24 | 70 |
| Ex.2 | 0.37 | 0.26 | 70 |
| Ex.3 | 0.51 | 0.36 | 70 |
| Ex.4 | 0.37 | 0.26 | 70 |
| Ex.5 | 0.17 | 0.12 | 70 |
| Ex.6 | 0.78 | 0.55 | 70 |
| Ex.7 | 1.02 | 0.71 | 70 |
| Comp.1 | 0.00 | 0.00 | 70 |
| Comp.2 | 0.35 | 0.24 | 70 |
| Comp.3 | 0.35 | 0.24 | 56 |

**Table 3**

| | Substrate to be printed | Pulse Voltage (V) | Conductive Film (µm) | | Line Resistance (Ω) | Volume Resistivity (µΩ · cm) |
|---|---|---|---|---|---|---|
| | | | Thickness | Line Width | | |
| Ex.1 | DF Color M70 | 2700 | 13.0 | 572 | 11.3 | 35.0 |
| Ex.2 | DF Color M70 | 2700 | 13.2 | 578 | 13.5 | 43.0 |
| Ex.3 | DF Color M70 | 2500 | 11.8 | 620 | 16.1 | 49.0 |
| Ex.4 | DF Color M70 | 2600 | 11.5 | 613 | 13.6 | 40.0 |
| Ex.5 | DF Color M70 | 2600 | 15.0 | 612 | 11.2 | 43.0 |
| Ex.6 | DF Color M70 | 2500 | 13.2 | 605 | 8.1 | 27.0 |
| Ex.7 | DF Color M70 | 2600 | 12.7 | 590 | 8.0 | 25.0 |
| Ex.8 | Mira Coat | 2600 | 15.5 | 600 | 8.8 | 34.0 |
| Ex.9 | Raicho Coat | 2600 | 15.7 | 608 | 10.8 | 43.0 |
| Comp.1 | DF Color M70 | 2800 | 14.6 | 611 | 16.7 | 62.0 |
| Comp.2 | DF Color M70 | 2400 | 7.0 | 720 | 23.0 | 48.3 |
| Comp.3 | DF Color M70 | - | - | - | - | - |

FIG. 2 shows the absorbance (Abs) of dispersing solutions in which about 0.05 % by weight of the fine copper particles (coated with BTA) in Example 1 and about 0.05 % by weight of fine copper particles (not coated with BTA), which were obtained by the same method as that in Example 1 except that the solution A contained no benzotriazole (BTA) serving as the dispersing agent, were added to ethylene glycol (EG), respectively, to be dispersed with ultrasonic waves, the absorbance being measured at a wavelength of 250 to 1100 nm by means of an ultraviolet and visible spectrophotometer (UV-1800 produced by Shimadzu Corporation). As shown in FIG. 2, in the solution in which BTA is dissolved in EG, the absorbance is increased at a wavelength of 300 nm or less due to the presence of the conjugated double band which absorbs light in the range of ultraviolet rays. Also, in the dispersing solution of the fine copper particles (coated with BTA) in Example 1, the absorbance is increased at a wavelength of 300 nm or less due to BTA coating the fine copper particles. However, it can be seen that the absorbance is not increased at a wavelength of 300 nm or less in the dispersing solution of the fine copper particles which are not coated with BTA.

### Industrial Applicability

If a conductive film produced from a conductive paste according to the present invention is used for forming an antenna for an RFID tag, such as an IC tag, which is incorporated to produce an inlay (comprising an IC chip and an antenna), it is possible to produce an RFID tag, such as an IC tag, which has a practical communication range.

## Claims

1. A conductive paste comprising:
fine copper particles having an average particle diameter of 1 to 100 nm, each of the fine copper particles being coated with an azole compound;
coarse copper particles having an average particle diameter of 0.3 to 20 *µ*m;
a resin;
a chlorine compound; and
a glycol solvent.

2. A conductive paste as set forth in claim 1, wherein said chlorine compound is at least one selected from the group consisting of sodium chloride, calcium chloride, chloroform and trichloroacetic acid.

3. A conductive paste as set forth in claim 1, wherein a total amount of said fine copper particles and said coarse copper particles in said conductive paste is 50 to 90 % by weight.

4. A conductive paste as set forth in claim 1, wherein a weight ratio of said fine copper particles to said coarse copper particles in said conductive paste is in the range of from 1:9 to 5:5.

5. A conductive paste as set forth in claim 1, wherein said azole compound is benzotriazole.

6. A conductive paste as set forth in claim 1, wherein said glycol solvent is ethylene glycol.

7. A conductive paste as set forth in claim 1, wherein said resin is at least one of a polyvinylpyrrolidone resin and a polyvinyl butyral resin

8. A conductive paste as set forth in claim 1, which further comprises a dispersing agent.

9. A method for producing a conductive film, the method comprising the steps of:
applying a conductive paste as set forth in claim 1, on a substrate; and
causing the applied paste to be preliminary-fired, and then, to be fired with light irradiation to form a conductive film on the substrate.

10. A method for producing a conductive film as set forth in claim 9, wherein the applying of said conductive paste is carried out by screen printing.

11. A method for producing a conductive film as set forth in claim 9, wherein the preliminary-firing is carried out by vacuum drying at 50 to 200 °C.

12. A method for producing a conductive film as set forth in claim 9, wherein the light irradiation is carried out by irradiating with light having a wavelength of 200 to 800 nm at a pulse period of 500 to 2000 *µ*s and a pulse voltage of 1600 to 3800 V.

13. A method for producing a conductive film as set forth in claim 9, wherein said conductive film has a thickness of 1 to 30 *µ*m.
